(19) Europäisches Patentamt
European Patent Office
Office européen des brevets

(11) **EP 4 760 309 A1**

(12) **EUROPEAN PATENT APPLICATION**
published in accordance with Art. 153(4) EPC

(43) Date of publication:
**17.06.2026  Bulletin 2026/25**

(21) Application number: **24886040.5**

(22) Date of filing: **30.09.2024**

(51) International Patent Classification (IPC):
*G01R 31/392* (2019.01)   *G01R 31/396* (2019.01)
*G01R 31/382* (2019.01)   *G01R 31/385* (2019.01)
*H01M 10/48* (2006.01)   *B60L 58/16* (2019.01)

(52) Cooperative Patent Classification (CPC):
**B60L 58/16; G01R 31/382; G01R 31/385;
G01R 31/392; G01R 31/396; H01M 10/48**

(86) International application number:
**PCT/KR2024/014832**

(87) International publication number:
**WO 2025/095362 (08.05.2025 Gazette 2025/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.10.2023  KR 20230146719**

(71) Applicant: **LG Energy Solution, Ltd.**
**Seoul 07335 (KR)**

(72) Inventors:
• **KIM, Geum Bee**
**Daejeon 34122 (KR)**

• **SEO, Bo Kyung**
**Daejeon 34122 (KR)**
• **KIM, Joo Sung**
**Daejeon 34122 (KR)**
• **KANG, Hee Chul**
**Daejeon 34122 (KR)**
• **KIM, Ji Na**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **BATTERY MANAGEMENT APPARATUS AND OPERATION METHOD THEREFOR**

(57)    A battery management apparatus according to an embodiment disclosed herein includes a data obtaining unit configured to obtain degradation score data including a storage degradation score with respect to state of charge (SOC) and temperature of batteries of each of a plurality of vehicles and state data of the batteries and a controller configured to calculate, based on the state data, a first score related to a cycle degradation degree of a target battery that is a battery of a target vehicle among the plurality of vehicles in a discharging section of the target vehicle, calculate, based on state data of the target battery and the degradation score data, a second score related to a storage degradation degree of the target battery in the discharging section of the target vehicle, and manage a state of the target battery by calculating a stress score of the target battery based on the first score and the second score.

FIG. 1

**Description**

## TECHNICAL FIELD

CROSS-REFERENCE TO RELATED APPLICATION

This application claims priority to and the benefit of Korean Patent Application No. 10-2023-0146719 filed in the Korean Intellectual Property Office on October 30, 2023, the entire content of which is incorporated herein by reference.

TECHNICAL FIELD

Embodiments disclosed herein relate to a battery management apparatus and an operating method thereof.

## BACKGROUND ART

Recently, research and development of secondary batteries have been actively performed. Herein, the secondary batteries, which are chargeable/dischargeable batteries, may be interpreted as including all of conventional nickel (Ni)/cadmium (Cd) batteries, Ni/metal hydride (MH) batteries, etc., and recent lithium-ion batteries. Recently, the lithium-ion battery is attracting attention as a next-generation energy storage medium as a usage range thereof is expanded to a power source of electric vehicles.

An electric vehicle is supplied with electricity from outside to charge a battery cell/module, and then the battery cell/module is discharged to drive a motor and obtain power. The battery cell/module undergoes internal deformation and denaturation through various charges/discharges in production and use phases, such that physical and chemical characteristics thereof change. A technique for diagnosing and managing operations of the battery cell/module due to degradation and deterioration of a battery is required.

A cause for degradation of a battery may include cycle degradation and storage degradation. Both cycle degradation and storage degradation may occur during use or storage of the battery.

## DISCLOSURE

## TECHNICAL PROBLEM

Embodiments disclosed herein aim to provide a battery management apparatus and an operating method thereof in which a degradation degree of a battery including both cycle degradation and storage degradation may be calculated to manage a degradation state of the battery.

Embodiments disclosed herein aim to provide a battery management apparatus and an operating method thereof in which a calculated degradation degree of a battery may be provided to a user to manage degradation of the battery.

Technical problems of the embodiments disclosed herein are not limited to the above-described technical problems, and other unmentioned technical problems would be clearly understood by one of ordinary skill in the art from the following description.

## TECHNICAL SOLUTION

A battery management apparatus according to an embodiment disclosed herein includes a data obtaining unit configured to obtain degradation score data including a storage degradation score with respect to state of charge (SOC) and temperature of batteries of each of a plurality of vehicles and state data of the batteries and a controller configured to calculate, based on the state data, a first score related to a cycle degradation degree of a target battery that is a battery of a target vehicle among the plurality of vehicles in a discharging section of the target vehicle, calculate, based on state data of the target battery and the degradation score data, a second score related to a storage degradation degree of the target battery in the discharging section of the target vehicle, and manage a state of the target battery by calculating a stress score of the target battery based on the first score and the second score.

According to an embodiment, the state data may include at least any one of voltage, current, power, temperature, SOC, and discharging time of a battery.

According to an embodiment, the controller may be further configured to calculate the first score based on an amount of power and an amount of current, consumed in the target battery in the discharging section.

According to an embodiment, the controller may be further configured to calculate the second score based on a weight average of a storage degradation score of the target battery, calculated using, as a weight value, a maintaining time of the target battery for each SOC and temperature of the target battery in the discharging section.

According to an embodiment, the controller may be further configured to standardize the first score and the second score and calculate the stress score of the target battery based on the standardized first score and second score.

According to an embodiment, the controller may be further configured to standardize the first score by dividing a difference between an average of the first score of each of vehicles of a same model as the target vehicle and the first score of the target vehicle by a standard deviation of the first score of each of the vehicles of the same model as the target vehicle.

According to an embodiment, the controller may be further configured to standardize the second score by dividing a difference between an average of the second score of each of the plurality of vehicles and the second score of the target vehicle by a standard deviation of the second score of each of the plurality of vehicles.

According to an embodiment, the controller may be further configured to calculate the stress score of the target battery by applying weights of cycle degradation and storage degradation to each of the standardized first score and second score.

A battery management method according to an embodiment disclosed herein includes obtaining degradation score data including a storage degradation score with respect to state of charge (SOC) and temperature of batteries of each of a plurality of vehicles and state data of the batteries, calculating, based on the state data, a first score related to a cycle degradation degree of a target battery that is a battery of a target vehicle among the plurality of vehicles in a discharging section of the target vehicle, calculating, based on state data of the target battery and the degradation score data, a second score related to a storage degradation degree of the target battery in the discharging section of the target vehicle, and managing a state of the target battery by calculating a stress score of the target battery based on the first score and the second score.

According to an embodiment, the state data may include at least any one of voltage, current, power, temperature, SOC, and discharging time of a battery.

According to an embodiment, the calculating of the first score may include calculating the first score based on an amount of power and an amount of current, consumed in the target battery in the discharging section.

According to an embodiment, the calculating of the second score may include calculating the second score based on a weight average of a storage degradation score of the target battery, calculated using, as a weight value, a maintaining time of the target battery for each SOC and temperature of the target battery in the discharging section.

According to an embodiment, the battery management method may further include standardizing the first score and the second score and calculating the stress score of the target battery based on the standardized first score and second score.

According to an embodiment, the standardizing of the first score may include standardizing the first score by dividing a difference between an average of the first score of each of vehicles of a same model as the target vehicle and the first score of the target vehicle by a standard deviation of the first score of each of the vehicles of the same model as the target vehicle.

According to an embodiment, the standardizing of the second score may include standardizing the second score by dividing a difference between an average of the second score of each of the plurality of vehicles and the second score of the target vehicle by a standard deviation of the second score of each of the plurality of vehicles.

According to an embodiment, the battery management method may further include calculating the stress score of the target battery by applying weights of cycle degradation and storage degradation to each of the standardized first score and second score.

## ADVANTAGEOUS EFFECTS

The battery management apparatus and the operating method thereof according to an embodiment disclosed herein may calculate a degradation degree of a battery including both cycle degradation and storage degradation to manage a degradation state of the battery.

The battery management apparatus and the operating method thereof according to an embodiment disclosed herein may provide the calculated degradation degree of the battery to a user to manage degradation of the battery.

In addition, various effects identified directly or indirectly through this document may be provided.

## DESCRIPTION OF DRAWINGS

FIG. 1 shows a system including a battery management apparatus according to an embodiment disclosed herein.
FIG. 2 shows a battery pack according to an embodiment disclosed herein.
FIG. 3 is a view showing degradation score data according to an embodiment disclosed herein.
FIG. 4 is a block diagram of a configuration of a battery management apparatus according to an embodiment disclosed herein.

FIG. 5 is a view for describing an output operation of a battery management apparatus, according to an embodiment disclosed herein.

FIG. 6 is an operating flowchart of a battery management apparatus according to an embodiment disclosed herein.

FIG. 7 is a block diagram showing a hardware configuration of a computing system for performing an operating method of a battery management apparatus, according to an embodiment disclosed herein.

## MODE FOR INVENTION

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element).

According to an embodiment of the disclosure, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. In the case of online distribution, at least a part of a computer program product may be at least temporarily stored in a machine-readable storage medium such as a memory of a server of a manufacturer, a server of an application store, or a relay server, or may be generated temporarily.

According to various embodiments of the disclosure, each of the above-described components (e.g., a module or program) may include a single entity or a plurality of entities, some of which may be separately disposed on other components. According to various embodiments of the disclosure, one or more of the above-described components or operations may be omitted or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments of the disclosure, operations performed by a module, a program, or other components may be executed sequentially, in parallel, repeatedly, or heuristically, or one or more of the operations may be executed in a different order or omitted, or one or more other operations may be added.

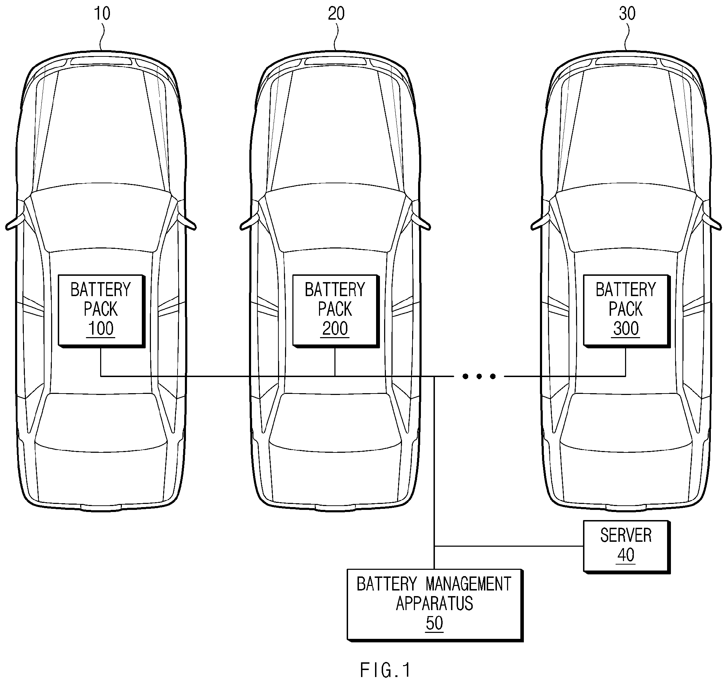

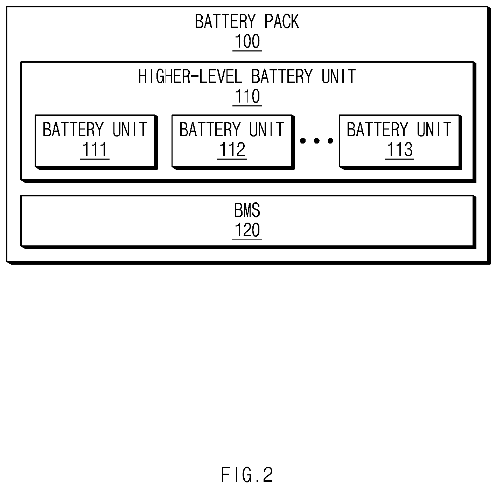

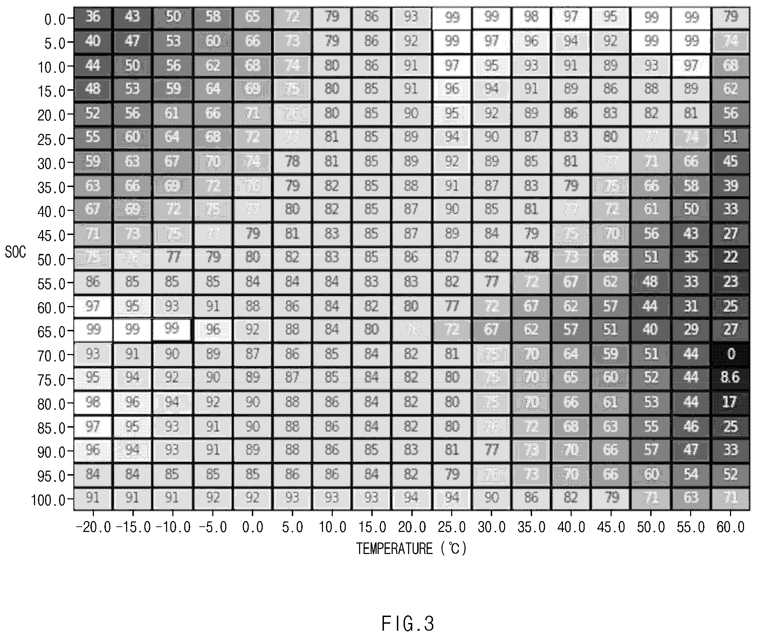

FIG. 1 shows a system including a battery management apparatus according to an embodiment disclosed herein. FIG. 2 shows a battery pack according to an embodiment disclosed herein. FIG. 3 is a view showing degradation score data according to an embodiment disclosed herein.

Referring to FIG. 1, the system may include a plurality of vehicles 10, 20, and 30, battery packs 100, 200, and 300 respectively included in the plurality of vehicles 10, 20, and 30, a server 40, and a battery management apparatus 50.

According to an embodiment, the plurality of vehicles 10, 20, and 30 may include electrical, electronic, or mechanical vehicles operating with power respectively supplied from the battery packs 100, 200, and 300. For example, the plurality of vehicles 10, 20, and 30 may include electric vehicles (EV) and/or two-wheel electric vehicles. Although the number of plural vehicles 10, 20, and 30 is 3 in FIG. 1, the present disclosure is not limited thereto, and the plurality of vehicles 10, 20, and 30 may include n vehicles (n is a natural number equal to or greater than 2).

According to an embodiment, the plurality of vehicles 10, 20, and 30 may include the same model of vehicles. For example, the plurality of vehicles 10, 20, and 30 may be models of the same specification produced by the same EV manufacturer. When the plurality of vehicles 10, 20, and 30 are of the same model, the specifications of components (e.g., the battery packs 100, 200, and 300, sensors, motors, acceleration devices, deceleration devices, etc.) respectively included in the plurality of vehicles 10, 20, and 30 are similar and the specifications of the plurality of vehicles 10, 20, and 30 (e.g., charging/discharging mechanisms, fuel efficiencies, etc.) are similar. Thus, the battery management apparatus 50 may obtain consistent information from the plurality of vehicles 10, 20, and 30 and improve the accuracy of battery diagnosis based on the obtained information.

According to an embodiment, the plurality of vehicles 10, 20, and 30 may include different models of vehicles. For example, the plurality of vehicles 10, 20, and 30 may be models of different specifications produced by the same EV manufacturer. When the plurality of vehicles 10, 20, and 30 are of different models, the battery management apparatus 50 may obtain quantitatively and qualitatively various information from the plurality of vehicles 10, 20, and 30. For example, the battery management apparatus 50 may obtain information from a greater number of vehicles of different models than vehicles of the same model, thereby quantitatively more information from the plurality of vehicles 10, 20, and 30. The battery management apparatus 50 may obtain qualitatively various information from the battery packs 100, 200, and 300 operating according to various specifications of vehicles of different models.

According to an embodiment, the battery packs 100, 200, and 300 may be provided in the vehicles 10, 20, and 30 to obtain information related to the battery in charging/discharging states or driving states of the vehicles 10, 20, and 30. The battery-related information may include voltage information of a battery in a charging or discharging section of the vehicles 10, 20, and 30, voltage information of a battery in the driving states of the vehicles 10, 20, and 30, etc. A detailed description of the battery packs 100, 200, and 300 will be provided below with reference to FIG. 2.

Referring to FIG. 2, the battery pack 100 may include a higher-level battery unit 110 and a battery management system (BMS) 120. The battery pack 100 may be included in the vehicle 10. For convenience of a description, the battery pack 100 included in the vehicle 10 is shown in FIG. 2, but the following description of the battery pack 100 is identically applicable to the battery packs 200 and 300 included in the vehicles 20 and 30.

The higher-level battery unit 110 may supply power to a target device (e.g., the vehicle 10). To this end, the higher-level battery unit 110 may be electrically connected to the target device. Herein, the target device may include an electrical, electronic, or mechanical device that operates by receiving power from the battery pack 100 including the higher-level battery unit 110. For example, the target device may be, but not limited to, an electric vehicle (EV) or an energy storage system (ESS).

The higher-level battery unit 110 may include a plurality of battery units 111, 112, and 113. For example, when the higher-level battery unit 110 is a battery module, the plurality of battery units 111, 112, and 113 may be a plurality of battery cells. For example, the plurality of battery units 111, 112, and 113 may be a lithium ion (Li-ion) battery, an Li-ion polymer battery, a nickel-cadmium (Ni-Cd) battery, a nickel hydrogen (Ni-MH) battery, etc., and are not limited thereto.

According to an embodiment, when the higher-level battery unit 110 is a battery module, the plurality of battery units 111, 112, and 113 may be a plurality of battery banks. The battery bank may be a set of a plurality of battery cells. For example, the battery bank may be a set of battery cells including n battery cells (n is a natural number of at least 2).

Although the number of higher-level battery units 110 is illustrated as 1 in FIG. 2, the present disclosure is not limited thereto, and the battery pack 100 may include n higher-level battery units (n is a natural number of at least 2). In addition, some components may be excluded from the battery pack 100 or other general-purpose components may be further included in the battery pack 100.

The BMS 120 may manage and/or control a state and/or an operation of the higher-level battery unit 110 and/or the plurality of battery units 111, 112, and 113.

Hereinbelow, for convenience of a description of operations of the BMS 120, each of the higher-level battery unit 110 and/or the plurality of battery units 111, 112, and 113 may be referred to as a battery unit 111, but may be substantially identically applied to the other battery units 112 and 113 or the higher-level battery unit 110.

According to an embodiment, the BMS 120 may collect state data of the battery unit 111 and manage the state of the battery unit 111 based on the collected state data. According to an embodiment, the BMS 120 may control an operation of the battery unit 111 and manage the operation of the battery unit 111 based on the controlled operation.

According to an embodiment, the BMS 120 may monitor a voltage, a current, and/or a temperature of the battery unit 111. A sensor or various measurement modules for monitoring, which are not shown, may be additionally installed in any position of the higher-level battery unit 110, a charging/discharging path, the plurality of battery units 111, 112, and 113, etc.

According to an embodiment, the BMS 120 may calculate state data regarding the state of the battery unit 111 based on a measurement value such as monitored voltage, current, temperature, etc. For example, the battery information regarding the state data of the battery unit 111 may include at least one of a state of charge (SOC), a state of health (SOH), a resistance, a current cycle, the remaining prediction cycle, and a C-rate.

According to an embodiment, the BMS 120 may further include an on-board diagnostic (OBD) device. The OBD device may include not only OBD-I, OBD 1.5, and OBD-II, but also various devices for outputting the state data of the battery unit 111 to another device (e.g., the server 40 and/or the battery management apparatus 50). The operation of the BMS 120 may also be performed in various devices such as a server, a cloud, a charger, a charger/discharger, etc., connected to the BMS in the battery pack 100 or a vehicle having the BMS 120 mounted thereon.

According to an embodiment, the BMS 120 may transmit battery state data to the server 40 and/or the battery management apparatus 50. According to an embodiment, the battery state data may include unique identification number information of the battery unit 111 as well as the foregoing data regarding the battery unit 111.

Referring back to FIG. 1, the server 40 may transmit and receive data to and from the vehicles 10, 20, and 30 and the battery management apparatus 50. For example, the server 40 may receive data regarding the vehicles 10, 20, and 30 from the BMS 120 and store and analyze the data, thereby providing a management service for the vehicles 10, 20, and 30 or the battery packs 100, 200, and 300.

According to an embodiment, the server 40 may store the data obtained from the BMS 120 in a database. The data stored in the database may be used for analyzing and/or managing a state of a battery of each of the plurality of vehicles 10, 20, and 30.

According to an embodiment, the server 40 may store various data for managing the state of the battery of each of the plurality of vehicles 10, 20, and 30 in the database. For example, the server 40 may store degradation score data related to the battery. Herein, the degradation score data may refer to data including storage degradation scores of batteries of the plurality of vehicles 10, 20, and 30 in various environments. For example, the storage degradation score may refer to data that scores a degradation degree of a battery over time when the battery is maintained at specific SOC and specific temperature. Matters related to the degradation score data will be described below with reference to FIG. 3.

Referring to FIG. 3, the server 40 may calculate the degradation score data through experiment. Herein, the degradation score data may refer to data including a storage degradation score of a battery with respect to SOC and temperature. According to an embodiment, the degradation score data may include data that scores a degree to which storage degradation of the battery occurs in each of a plurality of predefined temperature sections and a plurality of predefined SOC sections of the battery.

According to an embodiment, the server 40 may calculate the degradation score data based on storage degradation data. For example, the server 40 may experimentally obtain the storage degradation data of the battery in each of the plurality of temperature sections (e.g., -20 °C to -15 °C, -15 °C to -10 °C, ..., 55 °C to 60 °C) and SOC sections (e.g., 0 to 5, 5 to 10, 10 to 15, ..., 95 to 100). Herein, the temperature sections and the SOC sections and a section interval are merely examples, and the server 40 may calculate the degradation score data at various section intervals for random sections. The server 40 may calculate SOH in each of the plurality of temperature sections and the plurality of SOC sections based on the storage degradation data, and scale the calculated SOH into a score between 0 to 100 to calculate the degradation score data.

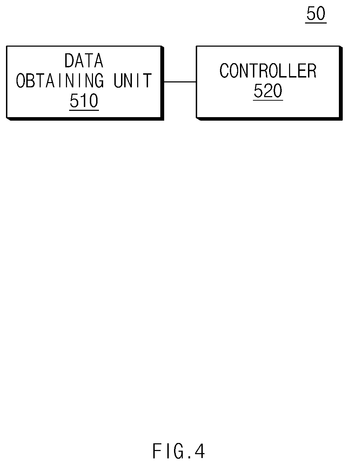

Referring back to FIG. 1, the battery management apparatus 50 may manage states of batteries included in the plurality of vehicles 10, 20, and 30. Matters related to operations of the battery management apparatus 50 will be described below with reference to FIG. 4.

FIG. 4 is a block diagram of a configuration of a battery management apparatus according to an embodiment disclosed herein.

Referring to FIG. 4, the battery management apparatus 50 may include a data obtaining unit 510 and a controller 520. However, without being limited thereto, some components may be omitted from the battery management apparatus 50 or other general-purpose components may be further included in the battery management apparatus 50.

The data obtaining unit 510 may obtain state data of a battery included in each of the plurality of vehicles 10, 20, and 30. According to an embodiment, the data obtaining unit 510 may obtain state data of each of the higher-level battery unit 110 and the plurality of battery units 111, 112, and 113 (hereinafter, referred to as batteries 110, 111, 112, and 113) included in each of the plurality of vehicles 10, 20, and 30. Herein, the state data of the battery may include at least one of SOC, SOH, a resistance, a current cycle, the remaining prediction cycle, and a C-rate.

According to an embodiment, the data obtaining unit 510 may obtain the state data of each of the batteries 110, 111, 112, and 113, measured for a predefined time period, every unit time. Herein, the batteries 110, 111, 112, and 113 may include the higher-level battery unit 110 and the plurality of battery units 111, 112, and 113. According to an embodiment, the data obtaining unit 510 may continuously obtain information related to voltage rise and drop in a charging section, a rest section after charging, a discharging section, and/or a rest section after discharging of the higher-level battery unit 110 and the plurality of battery units 111, 112, and 113.

According to an embodiment, the data obtaining unit 510 may obtain battery state data in a discharging section of the batteries 110, 111, 112, and 113 of the plurality of vehicles 10, 20, and 30. Herein, the discharging section may include a section in which the batteries 110, 111, 112, and 113 are continuously in a discharged state. According to an embodiment, the discharging section may also refer to a section including one or more sections in the discharged state and one or more sections in a rest state.

According to an embodiment, the data obtaining unit 510 may obtain battery state data in the discharging section of the batteries 110, 111, 112, and 113 of the plurality of vehicles 10, 20, and 30 in a driving section of each of the plurality of vehicles 10, 20, and 30. The data obtaining unit 510 may obtain the battery state data of the batteries 110, 111, 112, and 113 in a discharging section other than the driving section of the vehicle 10, 20, or 30. In this way, the battery management apparatus 50 may calculate a stress score related to degradation of a battery based on battery state data obtained in various battery discharging situations.

The controller 520 may control the operations of the battery management apparatus 50. The controller 520 may also manage states of the batteries 110, 111, 112, and 113 of each of the plurality of vehicles 10, 20, and 30. According to an embodiment, the controller 520 may identify a degradation state of each of the batteries 110, 111, 112, and 113 and manage a state of each of the batteries 110, 111, 112, and 113, based on the state data of the batteries 110, 111, 112, and 113 obtained by the data obtaining unit 510.

According to various embodiments, the battery may undergo change in physical and chemical features thereof and degradation while experiencing internal deformation and degeneration through various charging and discharging at production and use stages. For example, venting due to internal short-circuit, external short-circuit, and lithium precipitation or an under-voltage defect in which a voltage of a battery cell decreases below a certain level may affect degradation of the battery. Moreover, various use environments (e.g., temperature, SOC, C-rate, electric energy, fast charging/discharging, etc.) in which the battery is used may affect degradation of the battery.

According to an embodiment, a factor affecting degradation of the battery may include cycle degradation and storage degradation. Herein, cycle degradation may refer to degradation of a battery cell occurring in charging or discharging of a battery, and storage degradation may refer to degradation of a battery cell over time in which a battery is left in a charged state. In another aspect, cycle degradation may occur as the battery is discharged in the discharging section of the battery, and storage degradation may occur as the battery is discharged and left in a specific state (e.g., SOC, temperature, etc.). Thus, there emerge a need for calculating a degree to which cycle degradation or storage degradation affects degradation of the battery in various use environments where the battery is used and managing the battery based on the degree.

According to an embodiment, the battery management apparatus 50 may calculate stress scores of the batteries 110, 111, 112, or 113, which quantifies a degree to which various use environments affect degradation of the battery 110. Herein, the battery management apparatus 50 may calculate the stress scores of the batteries 110, 111, 112, and 113 based on both cycle degradation and storage degradation of the batteries 110, 111, 112, and 113. The battery management apparatus 50 may manage a state of the battery based on the stress scores of the batteries 110, 111, 112, and 113.

According to an embodiment, the controller 520 may calculate a stress score of a target battery (e.g., 110) that is a battery of a target vehicle (e.g., 10). Herein, the target battery may refer to a battery that is subject to stress score calculation, and the target vehicle may refer to a vehicle including the target battery that is subject to stress score calculation.

According to an embodiment, the controller 520 may calculate the stress score of the target battery 110 based on at least one of a first score $S_{cycle}$ and a second score $S_{storage}$. Herein, the first score $S_{cycle}$ may refer to a score related to a degree of cycle degradation of the target battery 110 in a discharging section of the target vehicle 10, and the second score $S_{storage}$ may refer to a score related to a degree of storage degradation of the target battery 110 in the discharging section of the target vehicle 10.

According to an embodiment, the controller 520 may calculate the first score $S_{cycle}$ of the target battery 110 based on state data of the target battery 110. Herein, the state data may include at least any one of voltage, current, power, temperature, SOC, and discharging time of the target battery 110. For example, the controller 520 may calculate the first score $S_{cycle}$ based on at least one of the voltage, current, power, temperature, and SOC of the state data of the target battery 110.

According to an embodiment, the controller 520 may calculate the first score $S_{cycle}$ based on the amount of power and the amount of current, consumed in the target battery 110 in the discharging section. In another aspect, the controller 520 may calculate the first score $S_{cycle}$ related to the degree of cycle degradation of the target battery 110 based on a weight average of a voltage variance calculated using, as a weight value, a magnitude of a current variance of the target battery 110. Herein, the weight average may refer to an average obtained by setting an importance or influence of a data value to the weight value when an arithmetic average of data is obtained.

According to various embodiments, when specific SOC is discharged in the target battery 110, the degree of cycle degradation of the target battery 110 may differ with whether a magnitude of a discharging current is large or small. The degree of cycle degradation of the target battery 110 may differ with a discharging temperature of the target battery 110 and a discharging SOC section of the target battery 110. For example, when the discharging current is strong, when the discharging temperature is low, when the discharging SOC section is low (i.e., the SOC is low), etc., more cycle degradation of the target battery 110 may occur.

Thus, the controller 520 may calculate the first cycle $S_{cycle}$ related to cycle degradation of the target battery 110 based on the amount of power and the amount of current with respect to temperature and SOC of the target battery 110 in the discharging section. In this way, the controller 520 may manage the degree of cycle degradation of the target battery 110 by scoring the degree of cycle degradation in the discharging section of the target battery 110. According to an embodiment, the controller 520 may calculate the first score $S_{cycle}$ based on Equation 1 below.

[Equation 1]

$$S_{cycle} = W/Q$$

Herein, $S_{cycle}$ may refer to a first score of the target battery 110, W may refer to the amount of power consumed in the target battery 110 in the discharging section, and Q may refer to the amount of current consumed in the target battery 110 in the discharging section.

According to an embodiment, the controller 520 may calculate the second score $S_{storage}$ of the target battery 110 based on degradation score data and the state data of the target battery 110. For example, the controller 520 may calculate the second score $S_{storage}$ by using the degradation score data obtained in the data obtaining unit 510 and the state data of the target battery 110. Herein, the second score $S_{storage}$ may refer to a storage degradation score with respect to SOC and temperature state of the target battery 110. A description related to the degradation score data has been made with reference to FIG. 3, and thus will not be repeated at this time.

According to an embodiment, the controller 520 may calculate the second score $S_{storage}$ based on a weight average of a storage degradation score of the target battery 110, calculated using, as the weight value, a time in the discharging section. Herein, the time may refer to a time of a state in which the target battery 110 is maintained for random SOC and temperature in the discharging section. The weight average may refer to an average obtained by setting an importance or influence of a data value to the weight value when an arithmetic average of data is obtained.

According to various embodiments, when the target battery 110 is maintained in a specific SOC section in the discharging section, the degree of storage degradation of the target battery 110 may differ with the SOC section. The degree of storage degradation of the target battery 110 may also differ with a predetermined temperature section maintained when the target battery 110 is discharged. For example, more storage degradation may occur when the target battery 110 is maintained in a low SOC section and a high-temperature section, and more storage degradation may occur when the target battery 110 is maintained in a high SOC section and a low-temperature section. Thus, the controller 520 may calculate the degree of storage degradation by using, as a weight value, a time for which the target battery 110 is maintained in a predetermined SOC section and a predetermined temperature section in the discharging section.

Thus, the controller 520 may calculate the second score $S_{storage}$ based on a weight average of a storage degradation score of the target battery 110, calculated using, as the weight value, a maintaining time of the target battery 110 for each SOC and temperature of the target battery 110 in the discharging section. In this way, the controller 520 may manage the degree of storage degradation of the target battery 110 by scoring the degree of storage degradation in the discharging section of the target battery 110.

According to an embodiment, the controller 520 may standardize the first score $S_{cycle}$ and the second score $S_{storage}$. Herein, standardization may refer to a random statistical standardization method. For example, the controller 520 may calculate a standardized first score $Z_{cycle}$ and a standardized second score $Z_{storage}$ by using an average-standard deviation standardization method, a Z-score normalization and range standardization method, etc.

According to an embodiment, the first score $S_{cycle}$ and the second score $S_{storage}$ before standardization may be different score scales. Thus, the controller 520 may calculate a stress score by integrating different score scales through standardization of the first score $S_{cycle}$ and the second score $S_{storage}$. The controller 520 may integrate the first score $S_{cycle}$ and the second score $S_{storage}$ having different distributions into a distribution having the same tendency by standardizing the first score $S_{cycle}$ and the second score $S_{storage}$. In this way, the controller 520 may more reliably calculate the stress score based on the standardized first score $Z_{cycle}$ and the standardized second score $Z_{storage}$.

According to an embodiment, the controller 520 may standardize the first score $S_{cycle}$ and the second score $S_{storage}$ based on different criteria. For example, the controller 520 may standardize the first score $S_{cycle}$ based on vehicles of the same model as the target vehicle 10 among the plurality of vehicles 10, 20, and 30. The vehicles of the same model as the target vehicle 10 may include similar batteries. Thus, the controller 520 may accurately standardize the first score $S_{cycle}$ related to the degree of cycle degradation of the target battery 110 by calculating the first score $S_{cycle}$ based on the vehicles of the same model as the target vehicle 10.

On the other hand, the controller 520 may standardize the second score $S_{storage}$ based on the plurality of vehicles 10, 20, and 30. Herein, the plurality of vehicles 10, 20, and 30 may include both the vehicles of the same model as or heterogeneous models to the target vehicle 10. As described above, the second score $S_{storage}$ related to the degree of storage degradation of the target battery 110 may be calculated based on storage degradation score data obtained through experiment on a random battery. Thus, the controller 520 may accurately standardize the second score $S_{storage}$ related to the storage degradation score of the target battery 110 by calculating the second score $S_{storage}$ based on vehicles of any type regardless of a model of the target vehicle 10.

According to an embodiment, the controller 520 may standardize the first cycle $S_{cycle}$ based on an average and a standard deviation calculated for vehicles of the same model as the target vehicle 10 among the plurality of vehicles 10, 20, and 30. For example, the controller 520 may standardize the first score $S_{cycle}$ by dividing a difference between an average of the first score $S_{cycle}$ of each of the vehicles of the same model as the target vehicle 10 among the plurality of vehicles 10, 20, and 30 and the first score $S_{cycle}$ of the target vehicle 10 by a standard deviation of the first score $S_{cycle}$ of each of the vehicles of the same model as the target vehicle 10. According to an embodiment, the controller 520 may standardize the first score $S_{cycle}$ based on Equation 2 below.

【Equation 2】

$$Z_{cycle} = (S_{cycle} - m^i_{cycle})/(\sigma^i_{cycle})$$

Herein, $Z_{cycle}$ may refer to the standardized first score $S_{cycle}$, $S_{cycle}$ may refer to a first score, i may refer to vehicles of the same model as the target vehicle 10, $m^i_{cycle}$ may refer to an average of first scores $S_{cycle}$ calculated based on the vehicles of the same model as the target vehicle 10, and $\sigma^i_{cycle}$ may refer to a standard deviation of the first score $S_{cycle}$ calculated based on the vehicles of the same model as the target vehicle 10.

According to an embodiment, the controller 520 may standardize the second score $S_{storage}$ based on the average and standard deviation calculated for the plurality of vehicles 10, 20, and 30. For example, the controller 520 may standardize the second score $S_{storage}$ by dividing a difference between the average of the second score $S_{storage}$ of each of the plurality of vehicles 10, 20, and 30 and the second score $S_{storage}$ of the target vehicle 10 by a standard deviation of the second score $S_{storage}$ of each of the plurality of vehicles 10, 20, and 30. According to an embodiment, the controller 520 may standardize the second score $S_{storage}$ based on Equation 3 below.

【Equation 3】

$$Z_{storage} = S_{storage} - m_{storage})/(\sigma_{storage})$$

Herein, $Z_{storage}$ may refer to a standardized second score $S_{storage}$, $S_{storage}$ may refer to a second score, $m_{storage}$ may refer to an average of second storages $S_{storage}$ calculated for the plurality of vehicles 10, 20, and 30, and $\sigma_{storage}$ may refer to a standard deviation of the second scores $S_{storage}$ calculated for the plurality of vehicles 10, 20, and 30.

According to an embodiment, the controller 520 may calculate a stress score $S_{stress}$ of the target battery 110 by applying weights of cycle degradation and storage degradation to each of the standardized first score $Z_{cycle}$ and the standardized second score $Z_{storage}$. For example, the controller 520 may determine the weights of cycle degradation and storage degradation contributing to the stress score $S_{stress}$. In this way, the controller 520 may determine a greater weight for one of cycle degradation and storage degradation, which has a greater influence upon degradation of the target battery 110. Thus, the controller 520 may accurately calculate the stress score $S_{stress}$ of the target battery 110 by considering both cycle degradation and storage degradation.

According to an embodiment, the controller 520 may calculate the stress score $S_{stress}$ by determining a ratio of cycle degradation to storage degradation as 1:1. The controller 520 may determine the weight of cycle degradation as being greater than that of cycle degradation or the weight of storage degradation being greater than that of cycle degradation.

According to an embodiment, the controller 520 may scale the stress score $S_{stress}$ to which the weights of cycle degradation and storage degradation are applied. Herein, scaling may refer to adjusting a size of data. Thus, the controller 520 may scale the stress score $S_{stress}$ such that the stress score $S_{stress}$ calculated from the battery 110 of each of the plurality of vehicles 10, 20, and 30 is distributed in a predetermined score section. In this way, the controller 520 may post-process a distribution of the stress score $S_{stress}$. The controller 520 may more clearly provide a user with the scaled stress score $S_{stress}$.

The controller 520 may scale the stress score $S_{stress}$ by using a random scaling method. For example, the controller 520 may scale the stress score $S_{stress}$ based on an average and a standard deviation in a predetermined score section in which the stress score $S_{stress}$ calculated from the battery 110 of each of the plurality of vehicles 10, 20, and 30 is to be distributed. According to an embodiment, the controller 520 may calculate the stress score $S_{stress}$ based on Equation 4 below.

【Equation 4】

$$S_{stress} = (k*(Z_{cycle}) + (1 - k)*(Z_{storage}))*\sigma_{score} + m_{score}$$

Herein, $S_{stress}$ may refer to a stress score, k may refer to a constant between 0 and 1, $Z_{cycle}$ may refer to the standardized first score, and $Z_{storage}$ may refer to the standardized second score. $\sigma_{score}$ may refer to a standard deviation of a predetermined score section in which the stress score $S_{stress}$ calculated from the battery 110 of each of the plurality of vehicles 10, 20, and 30 is to be distributed, and $m_{score}$ may refer to an average of the predetermined score section in which the stress score $S_{stress}$ calculated from the battery 110 of each of the plurality of vehicles 10, 20, and 30 is to be distributed.

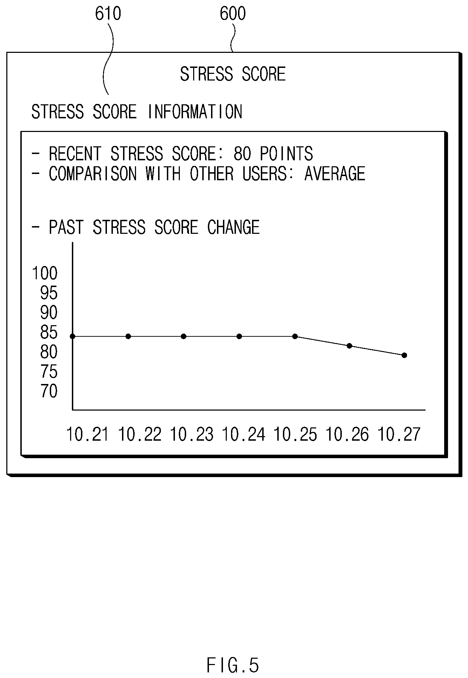

FIG. 5 is a view for describing an output operation of a battery management apparatus, according to an embodiment disclosed herein.

Referring to FIG. 5, the controller 520 may output stress score information 610 related to the stress score $S_{stress}$, as indicated by 600. Herein, the stress score information 610 may include recent stress score items, items to be compared with other users, past stress score change items of the target battery 110, etc. The stress score information 610 is not limited thereto, and may further include various information. For example, the controller 520 may output an action guideline for delaying degradation of the target battery 110 based on the stress score $S_{stress}$.

According to an embodiment, the controller 520 may provide in detail a score (e.g., the first score $S_{cycle}$ or the standardized first score $Z_{cycle}$) related to cycle degradation of the target battery 110 and a score (e.g., the second score $S_{storage}$ or the standardized second score $Z_{storage}$) related to storage degradation, based on a user's input during output of the stress score $S_{stress}$.

Through the stress score $S_{stress}$, the user may intuitively analyze whether a use environment or a use habit of the target battery 110 has a positive or negative influence upon degradation of the target battery 110. Thus, the user may set up an appropriate use plan based on the stress score $S_{stress}$ of the target battery 110.

According to an embodiment, the controller 520 may provide information about the stress score $S_{stress}$ to the user terminal through a communication unit (not shown) and may also provide information about the stress score $S_{stress}$ through a display included in a vehicle, a charger, etc.

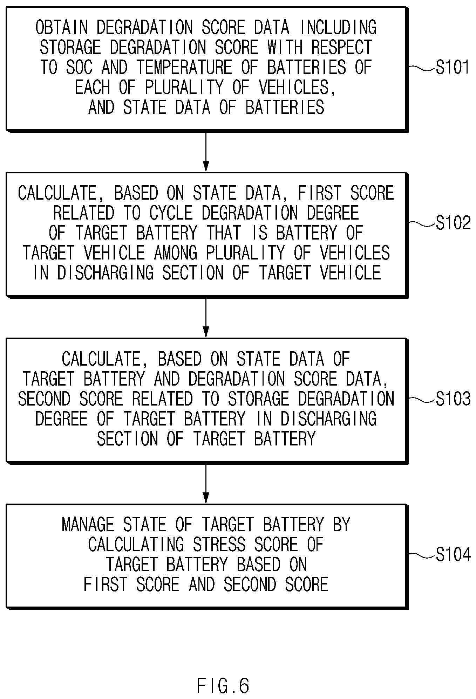

FIG. 6 is an operating flowchart of a battery management apparatus according to an embodiment disclosed herein.

Operations shown in FIG. 6 may be performed by the battery management apparatus 50 of FIG. 1. Operations in the following embodiment may be sequentially performed, but may not be necessarily performed sequentially. For example, the order of the operations may be changed, and at least two operations may be performed in parallel. At least one of the following operations may be omitted according to an embodiment.

Referring to FIG. 6, the battery management apparatus 50 may obtain degradation score data including a storage degradation score with respect to SOC and temperature of batteries of each of a plurality of vehicles and state data of the batteries in operation S101, calculate a first score related to a cycle degradation degree of a target battery that is a battery of a target vehicle among the plurality of vehicles in a discharging section of the target vehicle based on the state data in operation S102, calculate a second score related to a storage degradation degree of the target battery in a discharging section of the target vehicle based on state data of the target battery and the degradation score data in operation S103, and manage a state of the target battery by calculating a stress score of the target battery based on the first score and the second score in operation S104.

In operation S101, the data obtaining unit 510 of the battery management apparatus 50 may obtain the degradation score data including the storage degradation score with respect to SOC and temperature of the batteries of each of the plurality of vehicles 10, 20, and 30, and the state data of the batteries.

In operation S102, the controller 520 of the battery management apparatus 50 may calculate the first score $S_{cycle}$ related to the cycle degradation degree of the target battery 110 that is a battery of the target vehicle 10 among the plurality of vehicles 10, 20, and 30, in the discharging section of the target vehicle 10, based on the state data.

In operation S103, the controller 520 may calculate the second score $S_{storage}$ related to the storage degradation degree of the target battery 110 in the discharging section of the target vehicle 10 based on the state data of the target battery and the degradation score data.

In operation S104, the controller 520 may calculate the stress score $S_{stress}$ of the target battery 110 based on the first score $S_{cycle}$ and the second score $S_{storage}$ to manage the state of the target battery 110.

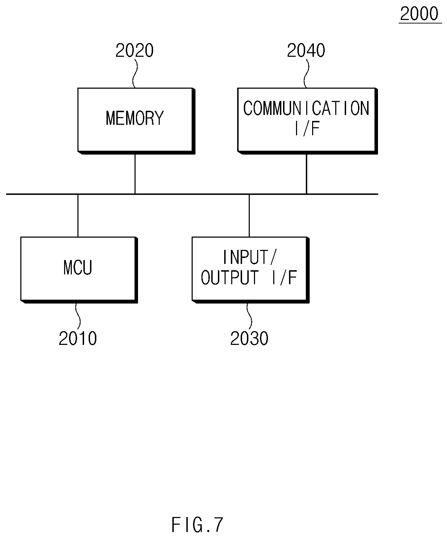

FIG. 7 is a block diagram showing a hardware configuration of a computing system for performing an operating method of a battery management apparatus, according to an embodiment disclosed herein.

Referring to FIG. 7, a computing system 2000 according to an embodiment disclosed herein may include a microcontroller unit (MCU) 2010, a memory 2020, an input/output interface (I/F) 2030, and a communication I/F 2040.

The MCU 2010 may be a processor that executes various programs (e.g., a battery cell feature data collection program, a latent variable extraction program, a distribution generation program, a battery cell diagnosis program, etc.) stored in the memory 2020, processes various information including feature data, latent variables, etc., of the battery cell through these programs, and executes the above-described functions of the battery management apparatus 50 shown in FIGS. 1 to 6.

The memory 2020 may store various programs such as a battery cell feature data collection program, a latent variable extraction program, a distribution generation program, a battery cell diagnosis program, etc. Moreover, the memory 2020 may store various information such as feature data, a latent variable, etc., of the battery cell.

The memory 2020 may be provided in plural, depending on a need. The memory 2020 may be a volatile or nonvolatile memory. For the memory 2020 as the volatile memory, random access memory (RAM), dynamic RAM (DRAM), static RAM (SRAM), etc., may be used. For the memory 2020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2020 are merely examples and are not limited thereto.

The input/output I/F 2030 may provide an interface for transmitting and receiving data by connecting an input device (not shown) such as a keyboard, a mouse, a touch panel, etc., and an output device such as a display (not shown), etc., with the MCU 2010.

The communication I/F 2040, which is a component capable of transmitting and receiving various data to and from a server, may be various types of devices capable of supporting wired or wireless communication. For example, the battery management apparatus 50 may transmit and receive various information including SOC, OCV, parameter, etc., of the battery cell from an external server separately provided through the communication I/F 2040.

As such, a computer program according to an embodiment disclosed herein may be recorded in the memory 2020 and processed by the MCU 2010, thus being implemented as a module that performs functions shown in FIG. 4.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The foregoing disclosure may roughly show features of several embodiments to allow those of ordinary skill in the art to better understand aspects of the present disclosure. Those of ordinary skill in the art will appreciate that they may readily use the present disclosure as a basis for designing or modifying other structures to carry out the same purposes or achieve the same advantages of the embodiments introduced herein. Additionally, it would be recognized by those of ordinary skill in the art that such equivalent configurations may not depart from the scope of the present disclosure, and various changes, substitutions, and modifications may be made herein without departing from the scope of the present disclosure.

**Claims**

1. A battery management apparatus comprising:

   a data obtaining unit configured to obtain degradation score data comprising a storage degradation score with respect to state of charge (SOC) and temperature of batteries of each of a plurality of vehicles and state data of the batteries; and
   a controller configured to:

   calculate, based on the state data, a first score related to a cycle degradation degree of a target battery that is a battery of a target vehicle among the plurality of vehicles in a discharging section of the target vehicle;
   calculate, based on state data of the target battery and the degradation score data, a second score related to a storage degradation degree of the target battery in the discharging section of the target vehicle; and
   manage a state of the target battery by calculating a stress score of the target battery based on the first score and the second score.

2. The battery management apparatus of claim 1, wherein the state data comprises at least any one of voltage, current, power, temperature, SOC, and discharging time of a battery.

3. The battery management apparatus of claim 2, wherein the controller is further configured to calculate the first score based on an amount of power and an amount of current, consumed in the target battery in the discharging section.

4. The battery management apparatus of claim 2, wherein the controller is further configured to calculate the second score based on a weight average of a storage degradation score of the target battery, calculated using, as a weight value, a maintaining time of the target battery for each SOC and temperature of the target battery in the discharging section.

5. The battery management apparatus of claim 1, wherein the controller is further configured to:

standardize the first score and the second score; and
calculate the stress score of the target battery based on the standardized first score and second score.

6. The battery management apparatus of claim 5, wherein the controller is further configured to standardize the first score by dividing a difference between an average of the first score of each of vehicles of a same model as the target vehicle and the first score of the target vehicle by a standard deviation of the first score of each of the vehicles of the same model as the target vehicle.

7. The battery management apparatus of claim 5, wherein the controller is further configured to standardize the second score by dividing a difference between an average of the second score of each of the plurality of vehicles and the second score of the target vehicle by a standard deviation of the second score of each of the plurality of vehicles.

8. The battery management apparatus of claim 5, wherein the controller is further configured to calculate the stress score of the target battery by applying weights of cycle degradation and storage degradation to each of the standardized first score and second score.

9. A battery management method comprising:

obtaining degradation score data comprising a storage degradation score with respect to state of charge (SOC) and temperature of batteries of each of a plurality of vehicles and state data of the batteries;
calculating, based on the state data, a first score related to a cycle degradation degree of a target battery that is a battery of a target vehicle among the plurality of vehicles in a discharging section of the target vehicle;
calculating, based on state data of the target battery and the degradation score data, a second score related to a storage degradation degree of the target battery in the discharging section of the target vehicle; and
managing a state of the target battery by calculating a stress score of the target battery based on the first score and the second score.

10. The battery management method of claim 9, wherein the state data comprises at least any one of voltage, current, power, temperature, SOC, and discharging time of a battery.

11. The battery management method of claim 10, wherein the calculating of the first score comprises calculating the first score based on an amount of power and an amount of current, consumed in the target battery in the discharging section.

12. The battery management method of claim 10, wherein the calculating of the second score comprises calculating the second score based on a weight average of a storage degradation score of the target battery, calculated using, as a weight value, a maintaining time of the target battery for each SOC and temperature of the target battery in the discharging section.

13. The battery management method of claim 9, further comprising:

standardizing the first score and the second score; and
calculating the stress score of the target battery based on the standardized first score and second score.

14. The battery management method of claim 13, wherein the standardizing of the first score comprises standardizing the first score by dividing a difference between an average of the first score of each of vehicles of a same model as the target vehicle and the first score of the target vehicle by a standard deviation of the first score of each of the vehicles of the same model as the target vehicle among the plurality of vehicles.

15. The battery management method of claim 13, wherein the standardizing of the second score comprises standardizing the second score by dividing a difference between an average of the second score of each of the plurality of vehicles and the second score of the target vehicle by a standard deviation of the second score of each of the plurality of vehicles.

16. The battery management method of claim 13, further comprising calculating the stress score of the target battery by applying weights of cycle degradation and storage degradation to each of the standardized first score and second score.

FIG.1

BATTERY PACK
100

HIGHER-LEVEL BATTERY UNIT
110

BATTERY UNIT
111

BATTERY UNIT
112

• • •

BATTERY UNIT
113

BMS
120

FIG.2

| SOC \ Temp (°C) | -20.0 | -15.0 | -10.0 | -5.0 | 0.0 | 5.0 | 10.0 | 15.0 | 20.0 | 25.0 | 30.0 | 35.0 | 40.0 | 45.0 | 50.0 | 55.0 | 60.0 |
|---|---|---|---|---|---|---|---|---|---|---|---|---|---|---|---|---|---|
| 0.0 | 36 | 43 | 50 | 58 | 65 | 72 | 79 | 86 | 93 | 99 | 99 | 98 | 97 | 95 | 99 | 99 | 79 |
| 5.0 | 40 | 47 | 53 | 60 | 66 | 73 | 79 | 86 | 92 | 99 | 97 | 96 | 94 | 92 | 99 | 99 | 74 |
| 10.0 | 44 | 50 | 56 | 62 | 68 | 74 | 80 | 86 | 91 | 97 | 95 | 93 | 91 | 89 | 93 | 97 | 68 |
| 15.0 | 48 | 53 | 59 | 64 | 69 | 75 | 80 | 85 | 91 | 96 | 94 | 91 | 89 | 86 | 88 | 89 | 62 |
| 20.0 | 52 | 56 | 61 | 66 | 71 | 76 | 80 | 85 | 90 | 95 | 92 | 89 | 86 | 83 | 82 | 81 | 56 |
| 25.0 | 55 | 60 | 64 | 68 | 72 | 77 | 81 | 85 | 89 | 94 | 90 | 87 | 83 | 80 | 77 | 74 | 51 |
| 30.0 | 59 | 63 | 67 | 70 | 74 | 78 | 81 | 85 | 89 | 92 | 89 | 85 | 81 | 77 | 71 | 66 | 45 |
| 35.0 | 63 | 66 | 69 | 72 | 76 | 79 | 82 | 85 | 88 | 91 | 87 | 83 | 79 | 75 | 66 | 58 | 39 |
| 40.0 | 67 | 69 | 72 | 75 | 78 | 80 | 82 | 85 | 87 | 90 | 85 | 81 | 77 | 74 | 61 | 50 | 33 |
| 45.0 | 71 | 73 | 75 | 77 | 79 | 81 | 83 | 85 | 87 | 89 | 84 | 79 | 75 | 70 | 56 | 43 | 27 |
| 50.0 | 75 | 76 | 77 | 79 | 80 | 82 | 83 | 85 | 86 | 87 | 82 | 78 | 73 | 68 | 51 | 35 | 22 |
| 55.0 | 86 | 85 | 85 | 85 | 84 | 84 | 84 | 83 | 83 | 82 | 77 | 72 | 67 | 62 | 48 | 33 | 23 |
| 60.0 | 97 | 95 | 93 | 91 | 88 | 86 | 84 | 82 | 80 | 77 | 72 | 67 | 62 | 57 | 44 | 31 | 25 |
| 65.0 | 99 | 99 | 99 | 96 | 92 | 88 | 84 | 80 | 76 | 72 | 67 | 62 | 57 | 51 | 40 | 29 | 27 |
| 70.0 | 93 | 91 | 90 | 89 | 87 | 86 | 85 | 84 | 82 | 81 | 75 | 70 | 64 | 59 | 51 | 44 | 0 |
| 75.0 | 95 | 94 | 92 | 90 | 89 | 87 | 85 | 84 | 82 | 80 | 75 | 70 | 65 | 60 | 52 | 44 | 8.6 |
| 80.0 | 98 | 96 | 94 | 92 | 90 | 88 | 86 | 84 | 82 | 80 | 75 | 70 | 66 | 61 | 53 | 44 | 17 |
| 85.0 | 97 | 95 | 93 | 91 | 90 | 88 | 86 | 84 | 82 | 80 | 76 | 72 | 68 | 63 | 55 | 46 | 25 |
| 90.0 | 96 | 94 | 93 | 91 | 89 | 88 | 86 | 85 | 83 | 81 | 77 | 73 | 70 | 66 | 57 | 47 | 33 |
| 95.0 | 84 | 84 | 85 | 85 | 85 | 86 | 86 | 84 | 82 | 79 | 75 | 73 | 70 | 66 | 60 | 54 | 52 |
| 100.0 | 91 | 91 | 91 | 92 | 92 | 93 | 93 | 93 | 94 | 94 | 90 | 86 | 82 | 79 | 73 | 63 | 71 |

TEMPERATURE (°C)

FIG.3

50

```
+------------------+      +------------------+
|      DATA        |      |                  |
|  OBTAINING UNIT  |------|   CONTROLLER     |
|      510         |      |      520         |
+------------------+      +------------------+
```

FIG.4

610    600

STRESS SCORE

STRESS SCORE INFORMATION

- RECENT STRESS SCORE: 80 POINTS
- COMPARISON WITH OTHER USERS: AVERAGE

- PAST STRESS SCORE CHANGE

```
100
 95
 90
 85  •——•——•——•——•
 80                      •
 75                         •
 70
    10.21 10.22 10.23 10.24 10.25 10.26 10.27
```

FIG.5

OBTAIN DEGRADATION SCORE DATA INCLUDING STORAGE DEGRADATION SCORE WITH RESPECT TO SOC AND TEMPERATURE OF BATTERIES OF EACH OF PLURALITY OF VEHICLES, AND STATE DATA OF BATTERIES ⌐S101

CALCULATE, BASED ON STATE DATA, FIRST SCORE RELATED TO CYCLE DEGRADATION DEGREE OF TARGET BATTERY THAT IS BATTERY OF TARGET VEHICLE AMONG PLURALITY OF VEHICLES IN DISCHARGING SECTION OF TARGET VEHICLE ⌐S102

CALCULATE, BASED ON STATE DATA OF TARGET BATTERY AND DEGRADATION SCORE DATA, SECOND SCORE RELATED TO STORAGE DEGRADATION DEGREE OF TARGET BATTERY IN DISCHARGING SECTION OF TARGET BATTERY ⌐S103

MANAGE STATE OF TARGET BATTERY BY CALCULATING STRESS SCORE OF TARGET BATTERY BASED ON FIRST SCORE AND SECOND SCORE ⌐S104

FIG.6

2000

2020                    2040

MEMORY            COMMUNICATION
                         I/F

MCU                INPUT/
                   OUTPUT I/F

2010               2030

FIG.7

EP 4 760 309 A1

# INTERNATIONAL SEARCH REPORT

| International application No. |
|---|
| **PCT/KR2024/014832** |

| | |
|---|---|
| **A.** | **CLASSIFICATION OF SUBJECT MATTER** |

**G01R 31/392**(2019.01)i; **G01R 31/396**(2019.01)i; **G01R 31/382**(2019.01)i; **G01R 31/385**(2019.01)i; **H01M 10/48**(2006.01)i; **B60L 58/16**(2019.01)i

According to International Patent Classification (IPC) or to both national classification and IPC

| | |
|---|---|
| **B.** | **FIELDS SEARCHED** |

Minimum documentation searched (classification system followed by classification symbols)

G01R 31/392(2019.01); B60L 3/00(2006.01); B60L 58/10(2019.01); G01R 31/36(2006.01); G01R 31/389(2019.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 사이클 퇴화(cycle degeneracy), 저장 퇴화(storage degeneracy), 점수(score), 표준화(standardization)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| X | KR 10-2020-0056716 A (LG CHEM, LTD.) 25 May 2020 (2020-05-25)<br>See paragraphs [0051], [0088], [0104]-[0115] and [0118]; claim 6; and figures 1-2. | 1-4,9-12 |
| A | | 5-8,13-16 |
| A | KR 10-2019-0005406 A (LG CHEM, LTD.) 16 January 2019 (2019-01-16)<br>See paragraphs [0081]-[0170]; and figures 3-4. | 1-16 |
| A | KR 10-2020-0095883 A (SK INNOVATION CO., LTD.) 11 August 2020 (2020-08-11)<br>See paragraphs [0038]-[0052]; and figures 5-6. | 1-16 |
| A | WO 2020-064932 A1 (RHEINISCH-WESTFALISCHE TECHNISCHE HOCHSCHULE (RWTH) AACHEN) 02 April 2020 (2020-04-02)<br>See page 1, line 1 – page 5, line 5. | 1-16 |

☑ Further documents are listed in the continuation of Box C.      ☑ See patent family annex.

| | |
|---|---|
| *    Special categories of cited documents: | "T"  later document published after the international filing date or priority date and not in conflict with the application but cited to understand the principle or theory underlying the invention |
| "A"  document defining the general state of the art which is not considered to be of particular relevance | |
| "D"  document cited by the applicant in the international application | "X"  document of particular relevance; the claimed invention cannot be considered novel or cannot be considered to involve an inventive step when the document is taken alone |
| "E"  earlier application or patent but published on or after the international filing date | |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search | Date of mailing of the international search report |
|---|---|
| **26 December 2024** | **26 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

21

## INTERNATIONAL SEARCH REPORT

International application No.

**PCT/KR2024/014832**

### C. DOCUMENTS CONSIDERED TO BE RELEVANT

| Category* | Citation of document, with indication, where appropriate, of the relevant passages | Relevant to claim No. |
|---|---|---|
| A | US 2023-0137625 A1 (GM GLOBAL TECHNOLOGY OPERATIONS LLC) 04 May 2023 (2023-05-04) See paragraphs [0005]-[0025]. | 1-16 |

## INTERNATIONAL SEARCH REPORT
### Information on patent family members

International application No.

**PCT/KR2024/014832**

| Patent document cited in search report | | | Publication date (day/month/year) | Patent family member(s) | | | Publication date (day/month/year) |
|---|---|---|---|---|---|---|---|
| KR | 10-2020-0056716 | A | 25 May 2020 | None | | | |
| KR | 10-2019-0005406 | A | 16 January 2019 | CN | 109964137 | A | 02 July 2019 |
| | | | | CN | 109964137 | B | 21 December 2021 |
| | | | | EP | 3531149 | A1 | 28 August 2019 |
| | | | | EP | 3531149 | A4 | 04 December 2019 |
| | | | | JP | 2020-0514680 | A | 21 May 2020 |
| | | | | JP | 6881577 | B2 | 02 June 2021 |
| | | | | KR | 10-2155333 | B1 | 11 September 2020 |
| | | | | US | 11239505 | B2 | 01 February 2022 |
| | | | | US | 2021-0288355 | A1 | 16 September 2021 |
| | | | | WO | 2019-009530 | A1 | 10 January 2019 |
| KR | 10-2020-0095883 | A | 11 August 2020 | CN | 111516549 | A | 11 August 2020 |
| | | | | CN | 111516549 | B | 08 March 2024 |
| | | | | EP | 3691018 | A1 | 05 August 2020 |
| | | | | EP | 3691018 | B1 | 24 July 2024 |
| | | | | KR | 10-2678203 | B1 | 26 June 2024 |
| | | | | US | 11374424 | B2 | 28 June 2022 |
| | | | | US | 2020-0251921 | A1 | 06 August 2020 |
| WO | 2020-064932 | A1 | 02 April 2020 | CN | 113196072 | A | 30 July 2021 |
| | | | | DE | 102018216517 | A1 | 26 March 2020 |
| | | | | DE | 102018216518 | A1 | 26 March 2020 |
| | | | | EP | 3847467 | A1 | 14 July 2021 |
| | | | | US | 11567140 | B2 | 31 January 2023 |
| | | | | US | 2022-0011373 | A1 | 13 January 2022 |
| US | 2023-0137625 | A1 | 04 May 2023 | CN | 116061689 | A | 05 May 2023 |
| | | | | DE | 102022122597 | A1 | 04 May 2023 |

Form PCT/ISA/210 (patent family annex) (July 2022)

**EP 4 760 309 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230146719